# EUROPEAN PATENT SPECIFICATION

(11) **EP 1 421 609 B1**
(45) Date of publication and mention of the grant of the patent: **26.03.2008**
(21) Application number: 02750283.0
(22) Date of filing: 23.07.2002
(51) Int. Cl.: H01L 21/302, B08B 6/00

(54) **PROCESS AND APPARATUS FOR TREATING A WORKPIECE SUCH AS A SEMICONDUCTOR WAFER**
PROZESS UND VORRICHTUNG ZUR BEHANDLUNG EINES ARBEITSSTÜCKS, WIE ZUM BEISPIEL EINES HALBLEITERWAFERS
PROCEDE ET DISPOSITIF DESTINES AU TRAITEMENT D'UNE PIECE, TELLE QU'UNE PLAQUETTE SEMI-CONDUCTRICE

(30) Priority: 06.08.2001 US 925884
(43) Date of publication of application: 26.05.2004
(73) Proprietor: SEMITOOL, INC., Kalispell, Montana 59901 (US)
(72) Inventor: KENNY, Michael, Kalispell, MT 59901 (US); AEGETER, Brian, Kalispell, MT 59901 (US); BERGMAN, Eric, Kalispell, MT 59901 (US); SCRANTON, Dana, Kalispell, MT 59901 (US)
(74) Representative: Viering, Jentschura & Partner
(86) International application number: PCT/US2002/023515
(87) International publication number: WO 2003/015146

(56) References cited:
- EP-A2- 0 548 596
- WO-A-99/52654
- US-A- 5 235 995
- US-A- 5 749 975
- US-A- 5 858 107
- US-A- 5 971 368
- US-B1- 6 240 933

## Description

Semiconductor devices are widely used in almost all consumer electronic products, such as telephones, computers, CD players, etc. as well as in communications, medical, industrial, military, and office products and equipment. Semiconductor devices are manufactured from semiconductor wafers. The cleaning of semiconductor wafers is often a critical step in the fabrication processes used to manufacture semiconductor devices. The geometries on wafers are often on the order of fractions of a micron, while the film thicknesses may be on the order of 20 Angstroms. This makes the devices manufactured from the wafers highly susceptible to performance degradation or failure due to organic, particulates or metallic/ionic contamination. Even silicon dioxide, which is used in the fabrication structure, can be considered a contaminant if the quality or thickness of the oxide does not meet design parameters.

Although wafer cleaning has a long history, the era of "modem" cleaning techniques is generally considered to have begun in the early 1970s when RCA developed a cleaning sequence to address the various types of contamination. Although others developed the same or similar processes in the same time frame, the general cleaning sequence in its final form is basically the same.

The first step of the RCA cleaning sequence involves removal of organic contamination using sulfuric acid and hydrogen peroxide mixtures. Ratios are typically in the range of 2:1 to 20:1, with temperatures in the range of 90 - 140 degrees C. This mixture is commonly called "piranha." A recent enhancement to the removal of organic contamination replaces the hydrogen peroxide with ozone that is bubbled or injected into the sulfuric acid line.

The second step of the process involves removal of oxide films with water and HF (49%) in ratios of200:1 to 10:1, usually at ambient temperatures. This processing typically leaves regions of the wafer in a hydrophobic condition.

The next step of the process involves the removal of particles and the re-oxidation of hydrophobic silicon surfaces using a mixture of water, hydrogen peroxide, and ammonium hydroxide, usually at a temperature of about 60 - 70 degrees C. Historically, ratios of these components have been on the order of 5:1:1. In recent years, that ratio has more commonly become 5:1:0.25, or even more dilute. This mixture is commonly called "SC1" (standard clean 1) or RCA1 Alternatively, it is also known as HUANG1. Although this portion of the process does an outstanding job of removing particles by simultaneously growing and etching away a silicon dioxide film on the surface of a bare silicon wafer (in conjunction with creating a zeta potential which favors particle removal), it has the drawback of causing metals, such as iron and aluminum, in solution to deposit on the silicon surface.

In the last portion of the process, metals are removed with a mixture of water, hydrogen peroxide, and hydrochloric acid. The removal is usually accomplished at around 60 -70 degrees C. Historically, ratios have been on the order of 5:1:1, but recent developments have shown that more dilute chemistries are also effective, including dilute mixtures of water and HC1. This mixture is commonly referred to as "SC2" (standard clean 2), RCA2, or HUANG2.

The foregoing steps are often run in sequence, constituting what is called a "pre-diffusion clean." Such a pre-diffusion clean insures that wafers are in a highly clean state prior to thermal operations which might incorporate impurities into the device layer or cause them to diffuse in such a manner as to render the device useless. Although this four-step cleaning process is considered to be the standard cleaning process in the semiconductor industry, there are many variations of the process that use the same sub-components. For example, the piranha solution may be dropped from the process, resulting in a processing sequence of: HF ->SC1 ->SC2. In recent years, thin oxides have been cause for concern in device performance, so "hydrofluoric acid last" chemistries have been developed. In such instances, one or more of the above-noted cleaning steps are employed with the final clean including hydrochloric acid in order to remove the silicon backside from the wafer surface.

The manner in which a specific chemistry is applied to the wafers can be as important as the actual chemistry employed. For example, HF immersion processes on bare silicon wafers can be configured to be particle neutral. HF spraying on bare silicon wafers typically shows particle additions of a few hundred or more for particles at 0.2 microns nominal diameter.

Although the four-chemistry clean process described above has been effective for a number of years, it nevertheless has certain deficiencies. Such deficiencies include the high cost of chemicals, the lengthy process time required to get wafers through the various cleaning steps, high consumption of water due to the need for extensive rinsing between chemical steps, and high disposal costs. The result has been an effort to devise, alternative cleaning processes that yield results as good as or better than the existing four chemistry clean process, but which are more economically attractive.

Various methods and apparatus have been developed in an attempt to improve cleaning of workpieces including semiconductor wafers. While these methods and apparatus have met with varying degrees of success, disadvantages remain in terms of cleaning effectiveness, time requirements, reliability, water and chemical supplies consumption, cost, and environmentally safe disposal of used water and chemicals.

WO 99/52654 A discloses a novel chemistry and application technique which is used in a chemical process sequence to address the contamination concerns of the microelectronic fabrication industry. These concerns are namely: minimizing contamination for organics, particles, metal/ions, and silicon dioxide.

### STATEMENT OF THE INVENTION

The present invention provides methods for cleaning a workpiece and an apparatus for removing contaminants from a workpiece as featured in the independent claims 1, 19 and 25. Preferred embodiments of this invention are described in the dependent claims 2 to 18, 20 to 24 and 26.

In a first aspect, a boundary layer of heated liquid is formed on a workpiece, by applying liquid onto the workpiece, and controlling the thickness of liquid on the workpiece. The thickness may be controlled by spinning the workpiece, or by controlling the flow rate of the liquid. Surfactants may optionally also be used. A jet of pressurized liquid is directed against the workpiece. The impact or impingement of the jet against the workpiece physically dislodges or removes a contaminant from the workpiece. Preferably, the liquid includes heated water, and may also include a chemical additive, to facilitate cleaning by chemical action, as well as by physical or mechanical liquid jet impingement cleaning. The liquid forming the boundary layer on the workpiece advantageously comes from the jet, although additional liquid sources, such as spray nozzles, may also be used. As the boundary layer is thin, the jet penetrates through the boundary layer and impinges against the workpiece, to clean the workpiece via impingement.

The workpiece and jet of pressurized liquid are moved relative to each other, so that preferably substantially all areas of the workpiece surface facing the jet are exposed at least momentarily to the jet, to remove contaminants via the physical impact or impingement of the jet against the workpiece surface. Rotating the workpiece allows the jet of pressurized liquid to contact more areas of the workpiece, and also may be used to form and maintain the boundary layer of liquid. The boundary layer of liquid immediately surrounding the area of impingement, where the jet impinges against the workpiece, is temporarily displaced by the jet. The boundary layer of liquid quickly reforms behind the jet, as the jet moves across or along the workpiece surface.

The elevated temperature promotes the reaction kinetics. A high concentration of ozone in the gas phase promotes diffusion of the ozone through the liquid film or boundary layer, even though the elevated temperature of the liquid film does not result in a solution having a high concentration of ozone dissolved in it. The jet impingement provides mechanical removal of contaminants, while the ozone (optionally with chemical additives in the liquid jet and boundary layer) provides chemical contaminant removal.

An ozone generator provides ozone into the environment containing the workpiece, such as a process chamber. The ozone diffuses through the liquid boundary layer, to chemically react with, and remove contaminants. Alternatively, the ozone gas may be injected into the liquid forming the jet.

In a second and separate aspect, steam, rather than liquid, is introduced, or jetted onto, the workpiece, with the steam preferably physically removing contaminants, and also heating the workpiece to speed up chemical cleaning.

In a third and separate aspect, the workpiece is irradiated with electromagnetic energy, such as ultraviolet, infrared, microwave, gamma or x-ray radiation.

In a fourth and separate aspect, sonic energy, such as ultrasonic or megasonic energy, is introduced to the workpiece, by direct contact between the workpiece and a transducer, or through the liquid jet.

In a fifth aspect, an apparatus for removing contaminants from a workpiece includes a fixture for holding a workpiece within a process chamber. At least one jet nozzle within the chamber is directed towards the workpiece. The jet nozzle is movable relative to the workpiece. A source of high-pressure liquid is connected to the jet nozzle. A fast-moving, high-pressure jet or column of liquid from the nozzle moves over substantially all of the workpiece surface facing the nozzle, as the nozzle and/or workpiece move relative to each other. The nozzle may advantageously be supported on a swing arm which pivots relative to the fixture. The nozzle may be above or below, or to one side of the workpiece so that the jet travels vertically up or down, or horizontally. Ozone is supplied into the chamber and diffuses through the boundary layer, to remove contaminants. A heater heats the liquid used to form the jet.

Accordingly, it is an object of the invention to provide an improved cleaning method and apparatus. The invention resides as well as subcombinations of the features, components, steps and subsystems shown and described. The optional features described in one embodiment or shown in one drawing figure may equally as well be used in any other embodiment.

### BRIEF DESCRIPTION OF THE DRAWINGS

Fig. 1 is a schematic block diagram of an apparatus for cleaning or processing a workpiece, such as a semiconductor wafer, with ozone injected or bubbled into the liquid.

Fig. 2 is a diagram illustrating a process flow for cleaning or processing a workpiece using a liquid and ozone.

Fig. 3 is a schematic diagram of an apparatus for cleaning or processing a workpiece in which the semiconductor workpiece using a liquid and ozone, and a chemical additive.

Fig. 4 is a schematic diagram of an apparatus for cleaning or processing a workpiece using ozone and a liquid, with the ozone supplied into the process chamber, rather than into the liquid as shown in Fig. 1.

Fig. 5 is a schematic diagram of an apparatus for cleaning or processing a workpiece using pressurized steam and ozone.

Fig. 6 is a schematic diagram of an apparatus for cleaning or processing a workpiece using liquid/gas contactors to enhance the kinetic reactions at the surface of the workpiece.

Fig. 7 is a schematic diagram of an apparatus similar to the apparatus of Fig. 4 and applying liquid onto the workpiece in a high pressure jet.

Fig. 8 is a schematic diagram of the apparatus shown in Fig. 7 with additional features.

Fig. 9 is a perspective view of a cleaning system including one or more of the apparatus shown in the Figs. listed above.

Fig. 10 is a top view of the system shown in Fig. 9.

Fig. 11 is a perspective view, in part section, of a process chamber, for use in any of the apparatus shown in Figs. 1-10.

Fig. 12 is a section view of an alternative process chamber for use in such apparatus.

Fig. 13 is a top view of the chamber shown in Fig. 12.

The schematic diagrams listed above conceptually show design and operation of aspects of the invention. The positions and connection techniques between the elements or components may of course be made in various ways, with the drawings showing such elements and connections schematically, and not physically or mechanically. Dotted lines in the drawings indicate optional and non-essential elements or connections. While showing preferred designs, the drawings include elements which may or may not be essential to the invention. The elements essential to the invention are set forth in the claims. The drawings show both essential and non-essential elements.

### DETAILED DESCRIPTION OF THE INVENTION

A workpiece or a microelectronic workpiece is defined here to include a workpiece formed from a substrate upon which microelectronic circuits or components, data storage elements or layers, and/or micro-mechanical elements are formed. The apparatus and methods described here may be used to clean or process workpieces such as semiconductor wafers, as well as other workpieces such as flat panel displays, hard disk media, CD glass, memory media, etc.

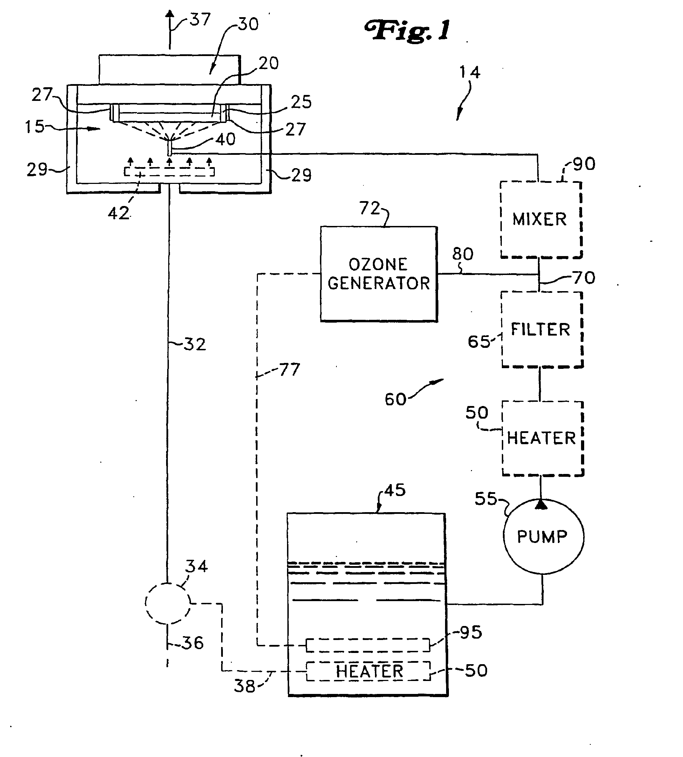

Although the apparatus is illustrated for use in single wafer processing, the apparatus and methods of Figs. 1-6 may also be used on a batch of workpieces. Turning now to Fig. 1, in a processing or cleaning system 14, a workpiece 20 is preferably supported within a process chamber 15 by one or more supports 25 extending from, for example, a rotor assembly 30. The rotor assembly 30 closes off the chamber. The rotor assembly may optionally seal with the chamber 15 to form a sealed processing environment, although a sealed chamber or environment is not required. The rotor assembly 30 spins the workpiece 20 about a spin axis 37 during or after processing with the ozone and the process liquid. The spin axis 37 is preferably vertical, although it may also have other orientations.

The volume of the chamber 15 is preferably minimized to as small as permitted by design considerations for any given capacity (i.e., the number and size of the workpieces to be processed). The chamber 15 is preferably cylindrical for processing multiple wafers in a batch. A flatter disk-shaped chamber is advantageously used for single wafer processing. Typically, the chamber volume will range from about 5 liters, (for a single wafer) to about 50 liters (for a 50 wafer system).

One or more nozzles 40 are disposed within the process chamber 15 to direct a spray mixture of ozone and liquid onto the surfaces of the workpiece 20. The nozzles 40 preferably direct a spray of liquid to the underside of the workpiece 20. However, the spray may be directed alternatively, or in addition, to the upper surface of the workpiece 20. The liquid may also be applied in other ways besides spraying, such as flowing, bulk deposition, immersion, condensation, etc.

The process liquid and ozone may be supplied to the nozzles 40 by a single fluid line carrying ozone mixed with the liquid. A reservoir 45 or tank holds the liquid. The reservoir 45 is connected to the input of a pump 55. The pump 55 provides the liquid under pressure along a fluid flow path 60, for supply to the nozzles 40. While use of a reservoir is preferred, any liquid source may be used, including a pipeline.

The liquid flow path 60 may optionally include a filter 65 to filter out microscopic contaminants from the process liquid. The process liquid, still under pressure, is provided at the output of the filter 65 (if used) along fluid flow line 70. One or more heaters 50 in the liquid flow path heat the process liquid. An in-line heater, or a tank heater, or both, may be used, as shown in Fig. 1.

Ozone is injected into the flow line 70. The ozone is generated by an ozone generator 72 and is supplied along an ozone supply line 80, under at least nominal pressure, to the fluid flow line 70. Optionally, the liquid, now injected with ozone, is supplied to the input of a mixer 90 that mixes the ozone and the process liquid. The mixer 90 may be static or active. From the mixer 90, the process liquid and ozone are provided to be input of nozzles 40. The nozzles spray the liquid onto the surface of the workpieces 20 that are to be treated and, further, introduce the ozone into the environment of the process chamber 15.

To further concentrate the ozone in the process liquid, an output line 77 of the ozone generator 72 may supply ozone to a dispersion unit 95 in the reservoir 45. The dispersion unit 95 provides a dispersed flow of ozone through the process liquid to thereby add ozone to the liquid before injection of a further amount of ozone along the fluid path 60.

In the embodiment of Fig. 1, spent liquid in the chamber 15 is optionally collected and drained via fluid line 32 to, for example, a valve 34. The valve 34 may be operated to provide the spent liquid to either a drain outlet 36 or back to the reservoir 45 via a recycle line 38. Repeated cycling of the process liquid through the system and back to the reservoir 45 assists in elevating the ozone concentration in the liquid through repeated ozone injection and/or ozone dispersion. The spent liquid may alternatively be directed from the chamber 15 to a waste drain.

The ozone generator 72 is preferably a high capacity ozone generator. One example of a high capacity ozone generator is the ASTeX 8403 Ozone Generator, manufactured by Applied Science and Technology, Inc., Woburn, Massachusetts, U.S.A. The ASTeX 8403 has an ozone production rating of 160 grams per hour. At this rate a flow of approximately 12 liters/minute and having a concentration of 19% ozone, by weight, can be supported. Another example of a suitable high capacity ozone generator is the Sumitomo GR-RL Ozone Generator, manufactured by Sumitomo Precision Products Co., Ltd., Hyogo, Japan which has an ozone production rating of 180g/hr. The ozone generator 72 preferably has a capacity of at least 90 or 100 grams per hour, or 110 or 120 grams per hour, with the capacity more preferably of at least 135 grams per hour. In terms of flow rate and concentration, the capacity should be at least 10 liters per minute at 12%, 13%, 14%, 15% ( or higher) concentration by weight. Lower flow rate applications, such as with single wafer processing, may have higher concentrations of e.g., 16-19 or greater.

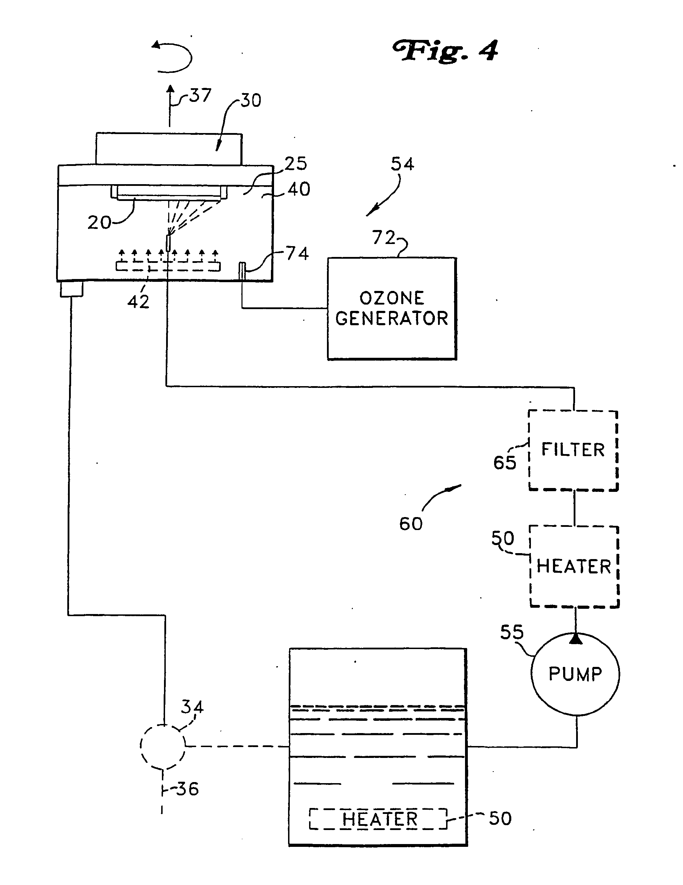

Use of a high capacity ozone generator is especially useful in connection with the methods and apparatus of Figs. 4, 5 and 7 where ozone is supplied as a gas into the process chamber or the environment around the workpiece, independent of the process fluid.

In previously known methods, ozone has been dissolved into an aqueous solution to make it available for the oxidation process on the surface of a wafer. As a result, the amount of ozone which could be delivered to the surface of the wafer, was limited to the amount of ozone which could be dissolved into the process fluid. Correspondingly, there was no incentive to use higher capacity ozone generators, because any excess ozone produced would not be absorbed by the process fluid, and would eventually dissipate and be lost.

Heating the surface of the workpiece 20 with a heated liquid supplied along with a flow of ozone to create an ozonated atmosphere is highly effective in photoresist stripping, ash removal, and/or cleaning processes. The liquid is supplied to the surface of the workpiece at an elevated temperature. This accelerates the surface reactions. It is also possible to directly heat the workpieces to stimulate the reactions. Such heating may take place in addition to or instead of the indirect heating of the workpiece through contact with the heated process liquid. For example, supports 25 may optionally include heating elements 27 that heat the workpiece 20. The chamber 15 may optionally include a chamber heater 29 for heating the chamber and indirectly heating the workpiece(s).

The preferred process liquid is de-ionized water. Other process liquids, such as other aqueous or non-aqueous solutions, may also be used. Water can form a continuous film on the workpiece surface. This film or layer, if excessively thick, acts as a diffusion barrier to the ozone, thereby slowing reaction rates. The thickness of this layer is controlled by controlling the spin speed of the workpiece, and controlled spraying of the process liquid, or a combination of one or more of these techniques, to form the liquid layer into a thin boundary layer. This allows the ozone to diffuse through the boundary layer of liquid, to the surface of the workpiece, where it reacts with the organic materials or other contaminants that are to be removed. Ozone has a limited solubility in the heated liquid (preferably water). However, ozone is readily able to diffuse through the liquid boundary layer and react with the surface of the workpiece or wafer (whether it is silicon, photoresist, etc.) at the liquid/solid interface. Thus diffusion, rather than dissolution, is the primary mechanism used to deliver ozone to the surfaces of the wafers.

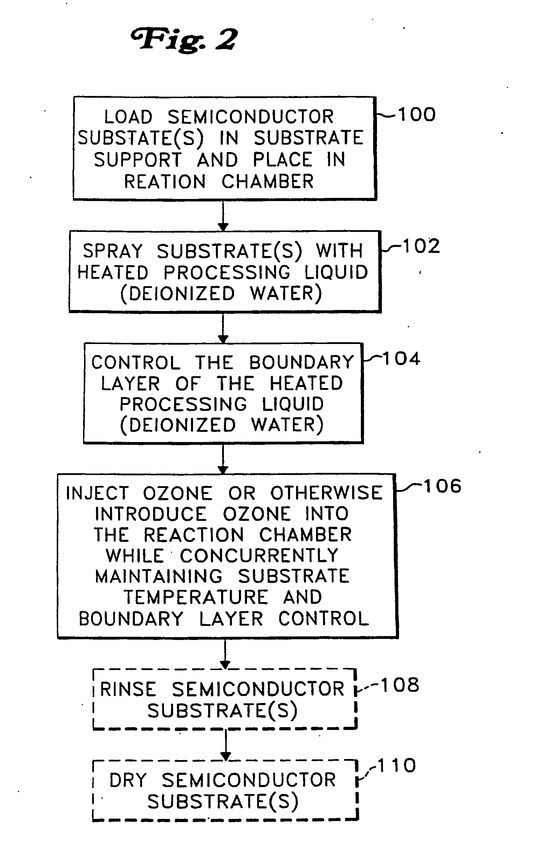

Fig. 2 illustrates a process that may be implemented in the system of Fig. 1 when the system 14 is used, for example, to strip photoresist from the surfaces of a workpiece. At step 100, the workpiece 20 to be stripped is placed in, for example, a holding fixture on the rotor assembly 30. For batch processing, a batch of workpieces may be placed into a cassette. Alternatively, for batch operations, the workpieces 20 may be disposed in chamber 15 in a carrierless manner, with an automated processing system, such as described in U.S. Patent No. 5,784,797.

The holding fixture or cassette is placed in a closed environment, such as in the chamber 15. At step 102, heated deionized water is sprayed onto the surfaces of the workpiece(s) 20. The heated deionized water heats the surfaces of the workpiece(s) 20 as well as the environment of the chamber 15. When the spray is discontinued, a thin liquid film remains on the workpiece surfaces. If the surface is hydrophobic, a surfactant may be added to the deionized water to assist in creating a thin liquid boundary layer on the workpiece surfaces. The surfactant may be used in connection with hydrophilic surfaces as well. Corrosion inhibitors may also be used.

The surface boundary layer of deionized water is controlled at step 104 using one or more techniques. For example, the workpiece(s) 20 may be rotated about axis 37 by the rotor 30 to generate centrifugal forces that thin the boundary layer. The flow rate of the deionized water may also be used to control the thickness of the surface boundary layer. Lowering of the flow rate results in decreased boundary layer thickness. Still further, the manner in which the deionized water is injected into the chamber 15 may be used to control the boundary layer thickness. The nozzles 40 may be designed to provide the deionized water as micro-droplets thereby resulting in a thin boundary layer.

At step 106, ozone is injected into the fluid flow path 60 during the water spray, or otherwise provided directly into the chamber 15. If the apparatus of Fig. 1 is used, the injection of the ozone preferably continues after the spray of water is shut off. If the workpiece surface begins to dry, a brief spray is preferably activated to replenish the liquid film on the workpiece surface. This ensures that the exposed workpiece surfaces remain wetted at all times and, further ensures that the workpiece temperature is and remains elevated at the desired reaction temperature. It has been found that a continuous spray of deionized water having a flow rate that is sufficient to maintain the workpiece surfaces at an elevated temperature, and high rotational speeds (i.e., > 300 rpm, between 300 and 800 rpm, or even as high as or greater than 1500 rpm) generate a very thin boundary layer which minimizes the ozone diffusion barrier and thereby leads to an enhanced photoresist stripping rate. Control of the boundary layer thickness is used to regulate the diffusion of ozone to the surface of the workpiece.

The liquid boundary layer thickness may range from a few molecular layers (e.g., about 1 micron), up to 100 microns, (typically 50-100 microns), or greater.

While ozone has a limited solubility in the heated deionized water, the ozone is able to diffuse through the water boundary layer and react with photoresist at the liquid/resist interface. The deionized water itself apparently further assists in the reactions by hydrolyzing the carbon-carbon bonds of organic deposits, such as photoresist, on the surface of the wafer. The elevated temperature promotes the reaction kinetics. The high concentration of ozone in the gas phase promotes diffusion of ozone through the liquid boundary layer, even though the high temperature of the liquid boundary layer does not actually have a high concentration of dissolved ozone.

Elevated or higher temperatures means temperatures above ambient or room temperature, that is temperatures above 20 or 25° and up to about 200°C. Preferred temperature ranges are 25-150°, more preferably 55-120° or 75-115°C, and still more preferably 85-105°C. In the methods described, temperatures of 90-100°C, and preferably centering around 95°C may be used.

After the workpiece(s) 20 have been processed through the reactions of the ozone and/or liquid, the workpiece(s) are optionally rinsed at step 108 and are dried at step 110. For example, the workpiece(s) may be sprayed with a flow of deionized water during the rinse at step 108. They may then be subject to any one or more known drying techniques at step 110.

Elevated temperatures are used to accelerate the reaction rates at the workpiece or wafer surface. One manner in which the surface temperature of the workpiece may be maximized is to maintain a constant delivery of heated process liquid, such as water or steam, during the process. The heated process liquid contacts and heats the workpiece during processing. However, such a constant delivery may result in significant waste of the water or other processing liquid. To conserve water and achieve the thinnest possible boundary layer, a "pulsed flow" of liquid or steam may be used. If the "pulsed flow" fails to maintain the requisite elevated workpiece surface temperature, an alternative manner of maintaining the surface temperature may be needed. One such alternative is the use of a "hot wall" reactor that maintains the surface and processing environment temperatures at the desired level. To this end, the process chamber may be heated by a chamber heater 29 in the form of, for example, one or more embedded heated recirculating coils or a heating blanket, or irradiation from a thermal source (e.g., and infrared lamp), etc.

In laboratory experiments, a 150 mm silicon wafer coated with 1 micron of photoresist was stripped in accordance with the teachings of the foregoing process. The processing chamber was pre-heated by spraying deionized water that was heated to 95 degrees C into the processing chamber for 10 minutes. During the cleaning process, a pulsed flow of deionized water heated to 95 degrees C was used. The pulsed flow included an "on time" of approximately five seconds followed by an "off time" of 10 seconds. The wafer was rotated at 800 rpm and the pulsed flow of deionized water was sprayed into the processing chamber through nine nozzles at a rate of 3 liters per minute. Ozone was injected into the processing chamber through a separate manifold at a rate of 8 liters per minute at a concentration of 12 percent. The resultant strip rate was 7234 Angstroms/min.

At a higher ozone flow rate, made possible by using a high capacity ozone generator for injecting ozone into the processing chamber at a rate of 12 liters per minute and having a concentration of 19 percent, the resultant strip rates can be further increased to in excess of 8800 Angstroms/minute.

There are many benefits resulting from the use of the processes described above. One of the most significant benefits is that the conventional 4-chem clean process may be reduced to a two-chemical step process while retaining the ability to remove organics, remove particulates, reduce metals and remove silicon dioxide. Process times, chemical consumption, water consumption and waste generation are all also significantly reduced. A further benefit of the foregoing process is its applicability to both FEOL and BEOL wafers and strip processes. Laboratory tests indicate that there is no attack on metals such as aluminum, titanium, tungsten, etc. A known exception is copper, which forms a copper oxide in the presence of ozone. This oxide is not a "hard" and uniform passivation oxide, such as the oxide that forms on metals like aluminum. As a result, the oxide can be readily removed.

A still further benefit is the higher ozone flow rates and concentrations can be used to produce higher strip rates under various processing conditions including lower wafer rotational speeds and reduced temperatures. Use of lower temperatures (between 25 and 75°C and preferably from 25-65°C (rather than at e.g., 95°C as described above) may be useful where higher temperatures are undesirable.

One example where this is beneficial is the use of the process with BEOL wafers, wherein metal corrosion may occur if the metal films are exposed to high temperature de-ionized water. Correspondingly, processing at ambient temperatures may be preferred. The gain in strip rates not realized, as a result of not using higher temperatures, is offset by increases in strip rate due to the increased ozone flow rates and concentrations. The use of higher ozone concentration can offset the loss of kinetic energy from using lower temperatures.

With reference again to Figure 2, it will be recognized that process steps 102-106 may be executed in a substantially concurrent manner. Additionally, it will be recognized that process steps 102-106 may be sequentially repeated using different processing liquids. In such instances, each of the processing liquids that are used may be specifically tailored to remove a respective set of contaminants. Preferably, however, it is desirable to use as few different processing liquids as possible. By reducing the number of different processing liquids utilized, the overall cleaning process is simplified and reducing the number of different processing liquids utilized minimizes chemical consumption.

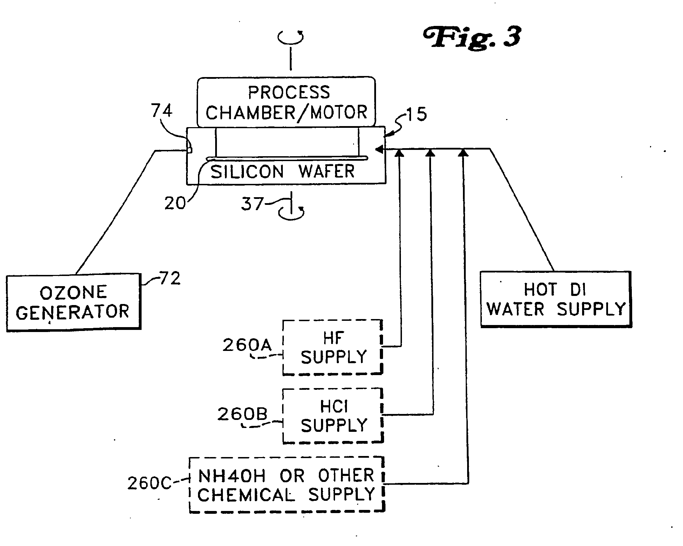

A single processing liquid may be used to remove organic contaminants, metals, and particles in a single cycle of process steps 102-106. The processing liquid is comprised of a solution of deionized water and one or more compounds, such as HF or HCl, from chemical reservoirs 260A or 260B, to form an acidic processing liquid solution, as shown in Fig. 3.

The use of a hydrofluoric acid solution in the process steps set forth at 102-106 provides numerous advantages, including the following:

1. Removal of organic contaminants - The oxidation capability of the process has been demonstrated repeatedly on photoresist. Strip rates often exceed 8800A/minute. Considering the fact that in cleaning applications, organic contamination is generally on the molecular level, the disclosed process has ample oxidation capacity.

2. Removal of oxide and regeneration of a controlled chemical oxide - Depending on the temperature of the solution and the concentration of HF in solution, a specific etch rate may be defined. However, the ozone will diffuse through the controlled boundary layer and regenerate the oxide to prevent the wafer from becoming hydrophobic. A 500:1 H₂0:HF mixture at 95 degrees C will etch Si0₂ at a rate of about 6-8A/minute. The same solution at 25 degrees C will etch Si0₂ at about 2A/minute. A typical "native" oxide is generally self limiting at a thickness of 8 - 12A, which is generally the targeted thickness for the oxide removal.

3. Removal of particles - Although the acidic solutions do not have the favorable zeta potential present in the SC1 clean noted above, particle removal in the disclosed process with an HF processing liquid has still been shown to be significant, as it uses the same removal mechanism of etching and regenerating the oxide surface.

4. Removal of metals - In laboratory experiments, wafers were intentionally contaminated with iron, nickel and copper. The disclosed process with an HF containing processing liquid showed a reduction in metals of over three orders of magnitude. As an added enhancement, HC*l* can be used in place of the HF to accomplish the metals removal, although this does not have the same degree of oxide and particle removal capability. The combination of HF and HC*l* is a further benefit, as each of these chemistries has significant metals removal capability, but the regeneration of the oxide surface in conjunction with the conversion of metals to metallic oxides and the symbiotic interaction of the two acid halides creates an exceptionally favorable environment for metal removal.

5. An oxide-free (hydrophobic) surface may be generated, if desired, by using a final HF step in an immersion cell or by use of an HF vapor step after the metals removal.

With the use of HF and ozone, the boundary layer is preferably maintained thick enough to achieve good etch uniformity, by selecting flow rates of liquid onto the workpiece surface, and removal rates of liquid from the workpiece surface. The boundary layer of the liquid on the workpiece surface is preferably maintained thick enough so that the etch uniformity is on the order of less than 5%, and preferably less than 3% or 2% (3-sigma divided by the mean).

In the HF and ozone process, the ozone concentration is preferably about 3 - 35% or 10-20% by weight (in oxygen). The ozone concentration is largely dependent on the etch rate of the aqueous HF solution used. When processing silicon, it is desirable that the silicon surface not be allowed to go hydrophobic, indicating the complete etching of the passivating silicon dioxide surface. HF concentration used is typically .001 to 10% or .01 to 1.0% (by weight). In general, the lower concentrations are preferred, with a concentration of about 0.1 % providing very good cleaning performance (with an etch rate of 8A of thermal oxide per minute at 95C). The HF solution may include hydrochloric acid to enhance metal removal capability. If used, the HCl typically has a range of concentrations similar to the ranges described above for HF.

In the HF and ozone process, a temperature range from 0°C up to 100°C may be used. Higher temperatures may be used if the process is conducted under pressure. Particle removal capability of this process is enhanced at elevated temperatures. At ambient temperature, the particle removal efficiency of dried silicon dioxide slurry particles with starting counts of around 60,000 particles larger than 0.15 microns, was about 95%. At 65°C, this efficiency increased to 99%. At 95°C, the efficiency increased to 99.7%. Although this may appear to be a slight improvement, the difference in final particle count went from 3000 to 300 to about 100 particles, which can be very significant in the manufacture of semiconductor devices.

The HF and ozone process may be included as part of a cleaning sequence, for example: 3:00 (minutes) of HF/03 > 3:00 SC1 > 3:00 HF/O3. In this sequence, the cleaning efficiency increased to over 99.9%. In contrast, the SC1 alone had a cleaning efficiency of only 50% or less. Similar results have been achieved when cleaning silicon nitride particles as well.

The steps and parameters described above for the ozone processes apply as well to the ozone with HF and ozone process. These processes may be carried out on batches of workpieces in apparatus such as described in U.S. Patent No. 5,544,421, or on individual workpieces in an apparatus such as described in PCT/US99/05676.

Typical chemical application times are in the range of 1:00 to 5:00 minutes. Compared to a 4-chem clean process time of around 20:00 minutes, the process with an HF and/or HCl containing processing liquid is highly advantageous. Typical H₂0:HF:HCl concentration ratios are on the order of 500: 1:1 to 50: 1: 1, with and without HF and/or HCl. Higher concentrations are possible, but the economic benefits are diminished. It is important to note that gaseous HF or HCI could be injected into water to create the desired cleaning chemistry as well. Due to differences in processor configurations and desired cleaning requirements, definition of specific cleaning process parameters will vary based on these differences and requirements.

The ozone diffusion process benefits include the following:

1. Reduction in the amount and types of chemicals used in the cleaning process.

2. Reduction in water consumption by the elimination of the numerous intermediate rinse steps required.

3. Reduction in process time.

4. Simplification of process hardware.

The processes described above are counter-intuitive. Efforts have been made for a number of years to replace hydrogen peroxide with ozone in chemistries such as SC1 and, to a lesser degree, SC2. These efforts have largely failed because they have not controlled the boundary layer and have not introduced the ozone in such a manner that diffusion through the boundary layer is the controlling mechanism instead of dissolution into the boundary layer. While the cleaning efficiency of conventional solutions is greatly enhanced by increasing temperature, it is recognized that the solubility of ozone in a given liquid solution is inversely proportional to the temperature of the solution. The solubility of ozone in water at 1 degrees C is approximately 100 ppm. At 60 degrees C, this solubility drops to less than 5 ppm. At elevated temperatures, the ozone concentration is thus insufficient to passivate (oxidize) a silicon wafer surface quickly enough to ensure that pitting of the silicon surface will not occur. Thus the two mechanisms are in conflict with one another when attempting to optimize process performance.

Tests have demonstrated that with the boundary layer control/ozone diffusion techniques described above, it is possible to process silicon wafers using a 2000:1 water: ammonium hydroxide solution at 95C and experience an increase surface roughness (RMS) of less than 2 angstroms. When this same solution is applied in an immersion system or in a conventional spray system, RMS surface roughness as measured by atomic force microscopy increases by more than 20 angstroms and the maximum surface roughness exceeds 190 angstroms. Additionally, while a conventional process will pit the surface to such a degree as to render the surface unreadable by a light-scattering particle counter, the boundary controlled technique has actually shown particle reductions of up to 50% on the wafer surface.

In the case of oxidizing and removing organic contamination, conventional aqueous ozone processes show a strip rate on photoresist (a hydrocarbon film) of around 200 - 700 angstroms per minute. In the boundary layer controlled system of the disclosed processes, the rate is accelerated to 2500 to 8800. angstroms per minute in a spray controlled boundary layer, or higher when the boundary layer is generated and controlled using steam at 15 psi and 126 degrees C.

The processes described are suitable for use in a wide range of microelectronic fabrication applications. One issue which is of concern in the manufacture of semiconductor devices is reflective notching. In order to expose a pattern on a semiconductor wafer, the wafer is coated with a photo-active compound called photoresist. The resistance film is exposed to a light pattern, thereby "exposing" the regions to which the light is conveyed. However, since topographic features may exist under the photoresist, it is possible for the light to pass through the photoresist and reflect off of a topographic feature. This results in resist exposure in an undesirable region. This phenomenon is known as "reflective notching." As device density increases, reflective notching becomes more of a problem.

A similar issue arises as a result of the reflectance normal to the incident angle of irradiation. Such reflectance can create distortions in the exposure beam through the phenomenon of standing wave formation, thereby resulting in pattern distortion in the photoresist. To reduce or prevent these phenomena, anti-reflective coating layers are used. The photoresist films are typically deposited either on top of or below an anti-reflective coating layer. Since both the photoresist layer and the anti-reflective coating layer are merely "temporary" layers used in intermediate fabrication steps, they must be removed after such intermediate fabrication steps are completed.

It has been found that the process of Figure 2 may be used with a processing liquid comprised of water and ammonium hydroxide to remove both the photoresist and the anti-reflective coating in a single processing step (e.g., the steps illustrated at 210-215). Although this has been demonstrated at concentrations between 0.02% and 0.04% ammonium hydroxide by weight in water, other concentrations are also considered to be viable. The ammonium hydroxide may be added to hot DI water from a storage reservoir 260C as shown in Fig. 3.

The process for concurrently removing photoresist and the corresponding antireflective layer is not necessarily restricted to processing liquids that include ammonium hydroxide. Rather, the principal goal of the additive is to elevate the pH of the solution that is sprayed onto the wafer surface. Preferably, the pH should be raised so that it is between about 8.5 and 11. Although bases such as sodium hydroxide and/or potassium hydroxide may be used for such removal, they are deemed to be less desirable due to concerns over mobile ion contamination. However, chemistries such as TMAH (tetra-methyl ammonium hydroxide) are suitable and do not elicit the same a mobile ion contamination concerns. Ionized water that is rich in hydroxyl radicals may also be used.

The dilute ammonium hydroxide solution may be applied in the process in any number of manners. For example, syringe pumps, or other precision chemical applicators, can be used to enable single-use of the solution stream. In such an embodiment, it becomes possible to strip the photoresist using a deionized water stream with ozone, and can conclude the strip with a brief period during which ammonium hydroxide is injected into the aqueous stream. This assists in minimizing chemical usage and waste generation. The application apparatus may also be capable of monitoring and controlling the pH the using the appropriate sensors and actuators, for example, by use of microprocessor control.

With reference to Fig. 4, in another ozone diffusion process system 54, one or more nozzles 74 are disposed within the process chamber 15 to conduct ozone from ozone generator 72 directly into the reaction environment or chamber interior. Injection of ozone into the fluid path 60 is optional. The system of Fig. 4 is otherwise the same as the Fig. 1 system described above.

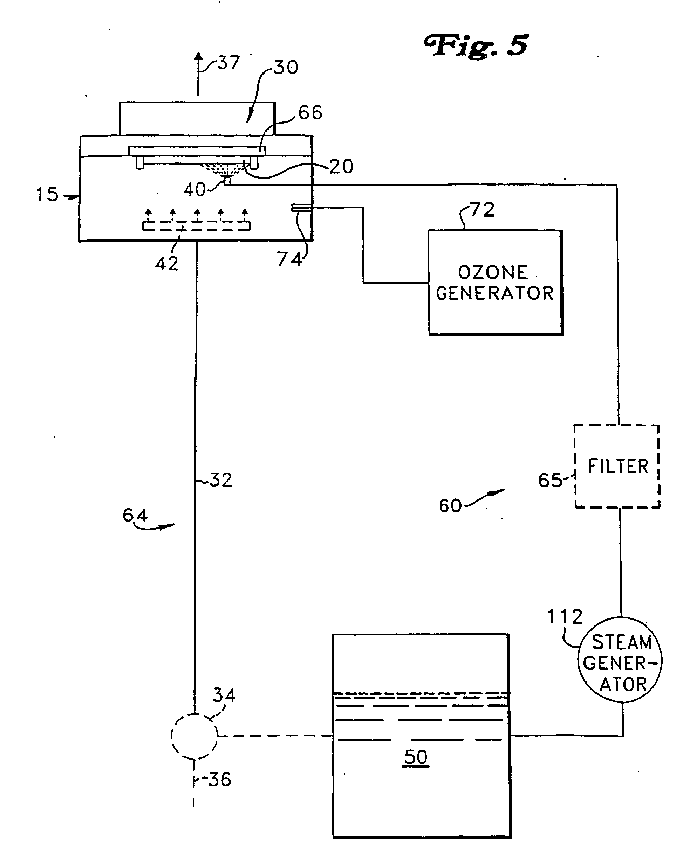

Referring to Fig. 5, in another ozone diffusion process system 64, a steam boiler 112 supplies saturated steam under pressure to the process chamber 15. No pump is needed. The reaction chamber 15 is preferably sealed to form a pressurized atmosphere around the workpiece. As an example, saturated steam at 126 degrees C is generated by steam boiler 112 and supplied to the chamber 15 to generate a pressure of 240kPa therein during the workpiece processing. Ozone may be directly injected into the chamber 15 as shown, and/or may be injected into the path 60 for concurrent supply with the steam. With this design, workpiece surface temperatures exceed 100 degrees C, further accelerating the reaction kinetics. While Figs. 4 and 5 show the fluid and ozone delivered via separate nozzles 40, they may also be delivered from the same nozzles, using appropriate valves.

Use of steam (water vapor at temperatures exceeding 100C) enhances the strip rate of photoresist in the presence of an ozone environment. Preliminary testing shows that a process using hot water at 95C produces a photoresist strip rate of around 3000 - 4000 angstroms per minute. Performing a similar process using steam at 120 - 130C results in a strip rate of around 7000 - 8000 angstroms per minute. However, the resultant strip rate is not sustainable.

The high strip rate is achieved only when the steam condenses on the wafer surface. The wafer temperature rapidly approaches thermal equilibrium with the steam, and as equilibrium is achieved, there is no longer a thermal gradient to promote the formation of the condensate film. This results in the loss of the liquid boundary layer on the wafer surface. The boundary layer appears to be essential to promote the oxidation of the organic materials on the wafer surface. The absence of the liquid film results in a significant drop in the strip rate on photoresist.

Additionally, once the steam ceases to condense on the wafer surface, the reaction environment experiences the elimination of an energy source to drive the reaction kinetics. As steam condenses on the wafer surface, it must relinquish the heat of vaporization, which is approximately 540 calories per gram. This energy then becomes available to promote other reactions such as the oxidation of carbon compounds in the presence of ozone or oxygen free radicals.

In view of these experimental observations, a method for maintaining the temperature of a surface such as a semiconductor wafer surface, is provided to ensure that condensation from a steam environment continues indefinitely, thereby enabling the use of steam in applications such as photoresist strip in the presence of ozone. Thus the formation of the liquid boundary layer is assured, as well as the release of significant amounts of energy as the steam condenses.

To accomplish this, the wafer surface must be maintained at a temperature lower than that of the steam delivered to the process chamber. This may be achieved by attaching the wafer to a temperature-controlled surface or plate 66, as shown in Fig. 5, which will act as a heat sink. This surface may then be temperature controlled either through the use of cooling coils, a solid-state heat exchanger, or other means.

In a preferred embodiment, a temperature-controlled stream of liquid is delivered to the back surface of a wafer, while steam and ozone are delivered to an enclosed process region and the steam is allowed to condense on the wafer surface. The wafer may be rotated to promote uniform distribution of the boundary layer, as well as helping to define the thickness of the boundary layer through centrifugal force. However, rotation is not an absolute requirement. The cooling stream must be at a temperature lower than the steam. If the cooling stream is water, a temperature of 75 or 85 - 95C is preferably used, with steam temperatures in excess of 100C.

In another embodiment, and one which is relatively easy to implement in a batch process, pulsed spray of cooling liquid is applied periodically to reduce the wafer temperature. Steam delivery may either be continuous or pulsed as well.

The wafer may be in any orientation and additives such as hydrofluoric acid, ammonium hydroxide or some other chemical may be added to the system to promote the cleaning of the surface or the removal of specific classes of materials other than or in addition to organic materials.

This process enables the use of temperatures greater than 100C to promote reaction kinetics in the water/ozone system for the purpose of removing organic or other materials from a surface. It helps ensure the continuous formation of a condensate film by preventing the surface from achieving thermal equilibrium with the steam. It also takes advantage of the liberated heat of vaporization in order to promote reaction rates and potentially allow the removal of more difficult materials which may require more energy than can be readily delivered in a hot water process.

An ultra-violet or infrared lamp 42 is optionally used in any of the designs described above, to irradiate the surface of the workpiece 20 during processing. Such irradiation further enhances the reaction kinetics. Although this irradiation technique is applicable to batch workpiece processing, it is more easily and economically implemented in the illustrated single wafer processing designs, where the workpiece is more easily completely exposed to the radiation. Megasonic or ultrasonic nozzles 40 may also be used.

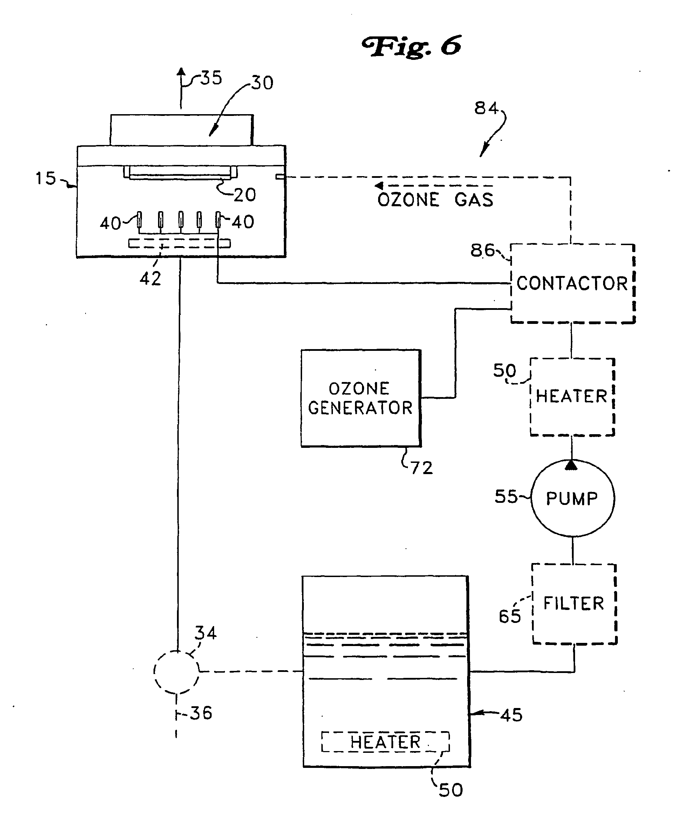

With reference to Fig. 6, in another alternative ozone processing system 84, one or more liquid-gas contactors 86 are used to promote the dissolution of ozone into the liquid. The contactors are especially useful when the temperature of the processing liquid is, for example, at or near ambient. Such low temperatures may be advantageous in some applications, to control corrosion on films such as aluminum/silicon/copper.

The contactor 86 is preferably of a parallel counter-flow design where liquid is introduced into one end and the ozone gas is introduced into the opposite end. Such contactors are available from e.g., W. L. Gore Corporation, Newark, Delaware, USA. These contactors operate under pressure, typically from about 1 to 4 atmospheres (gauge). The undissolved gas exiting the contactor 86 may be optionally directed to the process chamber 320 to minimize gas losses. However, the ozone supply 72 for the contactor 86 may or may not be the same as the supply for direct delivery to the process chamber 15.

As described, the ozone gas may be separately sprayed, or otherwise introduced as a gas into the process chamber, where it can diffuse through the liquid boundary layer on the workpiece. The fluid is preferably heated and sprayed or otherwise applied to the workpiece, without ozone injected into the fluid before the fluid is applied to the workpiece.

Alternatively, the ozone may be injected into the fluid, and then the ozone containing fluid applied to the workpiece. In this embodiment, if the fluid is heated, the heating preferably is performed before the ozone is injected into the fluid, to reduce the amount of ozone breakdown in the fluid during the fluid heating. Typically, due to the larger amounts of ozone desired to be injected into the fluid, and the low solubility of the ozone gas in the heated fluid, the fluid will contain some dissolved ozone, and may also contain ozone bubbles.

It is also possible to use aspects of both embodiments, that is to introduce ozone gas directly into the process chamber, and to also introduce ozone into the fluid before the fluid is delivered into the process chamber. Thus, various methods may be used for introducing ozone into the chamber.

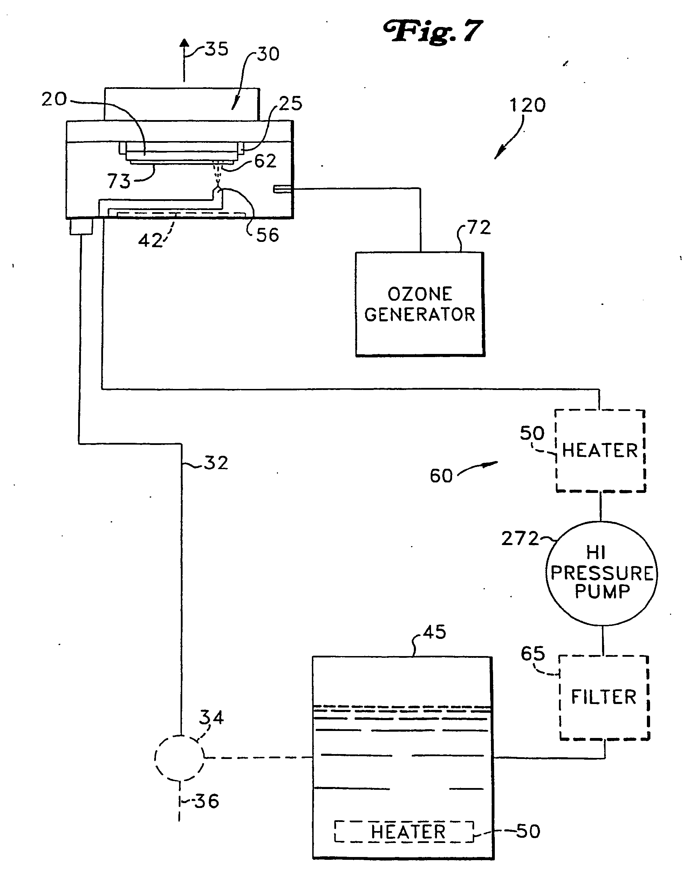

Referring to Fig. 7, another alternative system 120 is similar to the system 54 shown in Fig. 4, except the system 120 does not use the spray nozzles 40. Rather one or more jet nozzles 56 are used to form a high pressure jet of liquid. The liquid 58 formed into the high pressure jet 62 penetrates through the boundary layer 73 of liquid on the workpiece surface and impinges on the workpiece surface with much more kinetic energy than in conventional water spray processes. The increased kinetic energy of the jet physically dislodges and removes contaminants.

A high pressure pump 272 preferably pressurizes the liquid 58 to a pressure of from 700-105,000 or 3500-14,000kPa and more preferably to approximately 3200-64001kPa. These pressures and the nozzle orifice diameter and jet diameter of 0.5-10mm, result in formation of a jet 62 or a substantially solid or continuous column of liquid impacting the workpiece at a velocity of 1-100 meters/second. Unlike conventional fluid spray systems, few, if any, droplets are formed. Rather, a concentrated jet or beam of liquid impacts on a small spot on the workpiece. The velocity of liquid is limited largely only by the pump pressure and flow limitations, and the need to avoid damaging the workpiece. While continuous flow is preferred, an interrupted or intermittent flow, to form discrete liquid impacts, may also be used.

Test data shows that the process described above can remove both hard baked and implanted photoresist, as well as particulate and metallic contaminants, at lower costs than other processes now used, involving plasma, and chemistries.

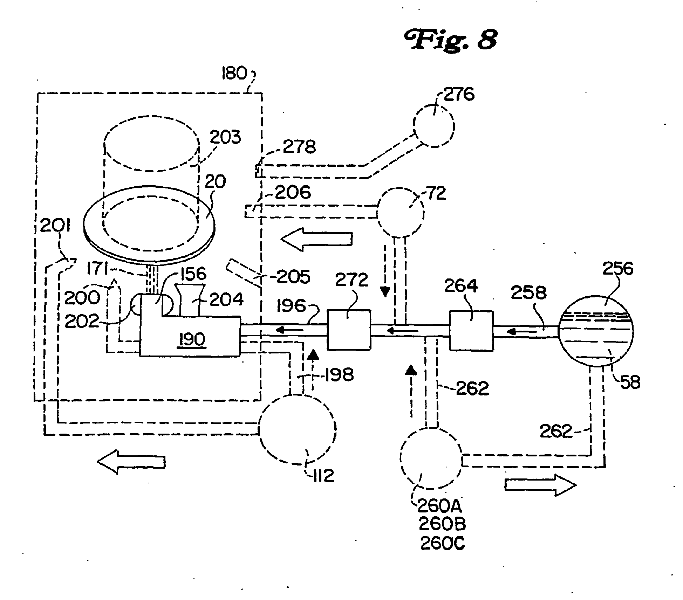

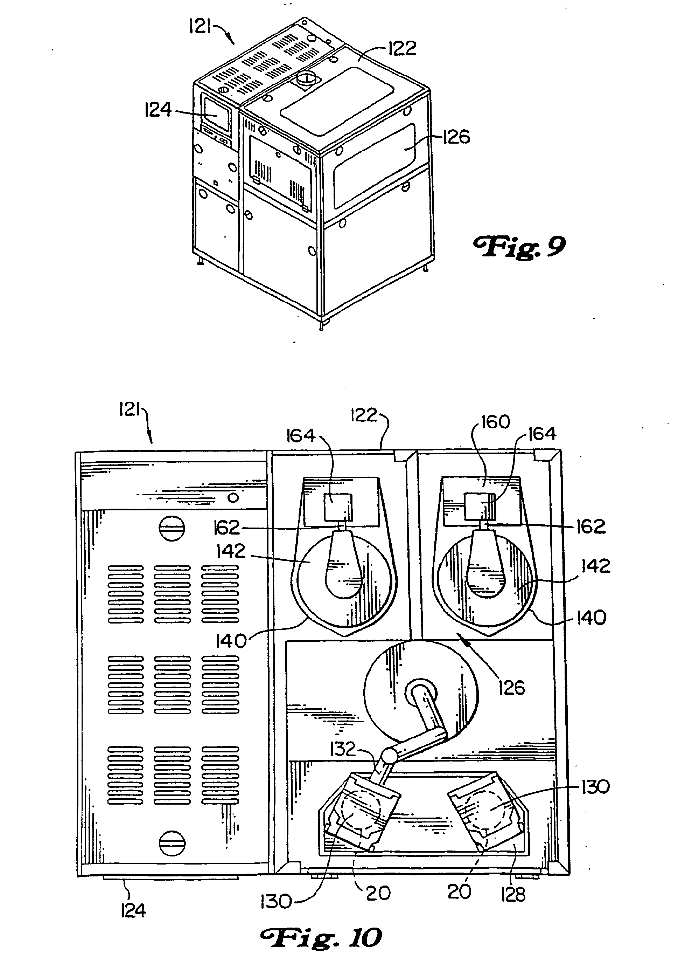

The liquid jet system shown in Fig. 7 may be included in an apparatus for handling and cleaning or processing workpieces. Figs. 8-13 show optional further designs and features which may be used with the liquid jet system of Fig. 7. As one example, referring to Fig. 9, an apparatus 121 including the jet system includes a control panel 124 and a process bay or space 126 within an enclosure 122. As shown in Fig. 10, a robot arm 132 is positioned in between a load/unload section 128, and the process section 126. Workpiece containers or carriers 130, typically holding a batch of workpieces 20, are moved into and out of the load/unload section 128, as workpieces are cycled through the system 121 for cleaning.

Process chambers 140 are positioned within the process section 126. In the design shown, two process chambers 140 are used. However, for certain applications, a single process chamber 140 may be sufficient, whereas in other applications, several process chambers, e.g., three, four, five, six or more, may be used.

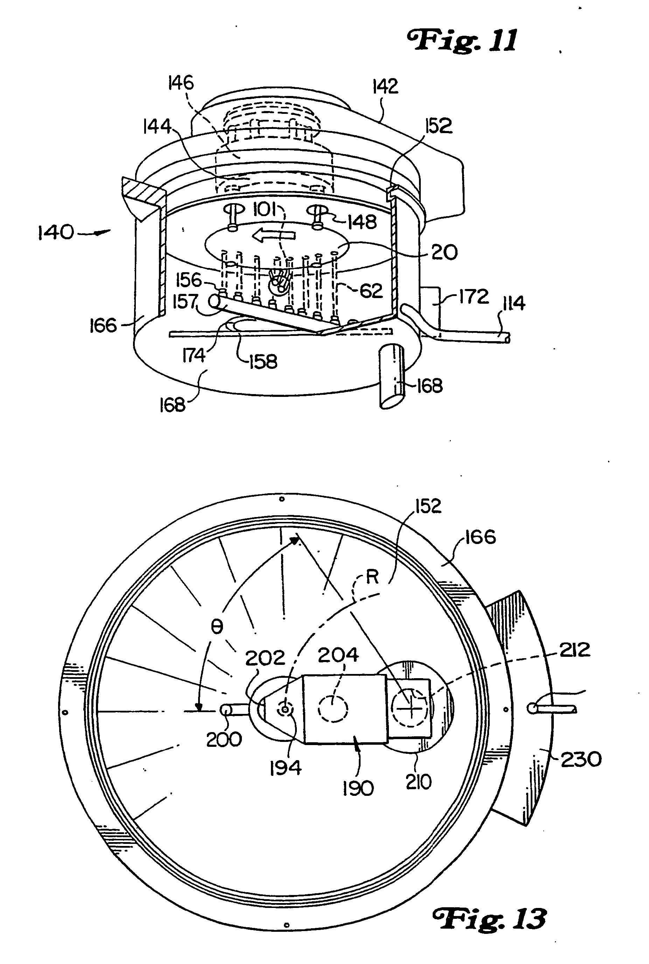

Referring now to Figs. 10 and 11, each process chamber 140 includes a head 142 having a fixture, or fingers 148 for holding a workpiece 20. One or more jet nozzles 56 are provided on a manifold 157 within the process chamber 140. The manifold 157 is advantageously movable along a manifold track 158, via a track motor 172. A supply line 174 supplies high-pressure liquid to the one or more nozzles 56.

The head 142 of the process chamber 140 preferably (but not necessarily) includes a rotor 144 attached to the finger holders or fixture 148. A motor 146 is then provided in the head 142 to spin the rotor 144, and the workpiece 20. In this way, a jet 62 of high-pressure liquid from the one or more nozzles 56 can contact substantially all areas of the bottom surface of the workpiece 20, via the rotation of the workpiece 20 and the preferably linear movement of the nozzle 56. Alternatively, the nozzle 56 may be fixed in position (without any manifold 154 used) and the workpiece 20 rotated with precession by the rotor 144. As another alternative, the workpiece 20 and nozzle 56 may both remain stationary, while the jet of high-pressure liquid is steered via a nozzle or jet steering device, so that the jet passes over substantially all of the lower surface of the workpiece 20.

Referring to Fig. 10, a head elevator 160 attached to the head 142 is provided to raise and lower the head 142 onto and away from the bowl 166 of the process chamber 140, to load and unload a workpiece into the head 142. The head 142 is attached to the head elevator 160 by a head pivot shaft 162. A pivot drive motor 164 turns the head pivot shaft 162 and the head 142, typically by 180°, so that the head is upfacing, for loading and unloading, and downfacing, for processing. A drain 168 near the bottom of the bowl 166 removes spent liquid, as shown in Fig. 11. A seal 152 is optionally provided between the head 142 and bowl 166.

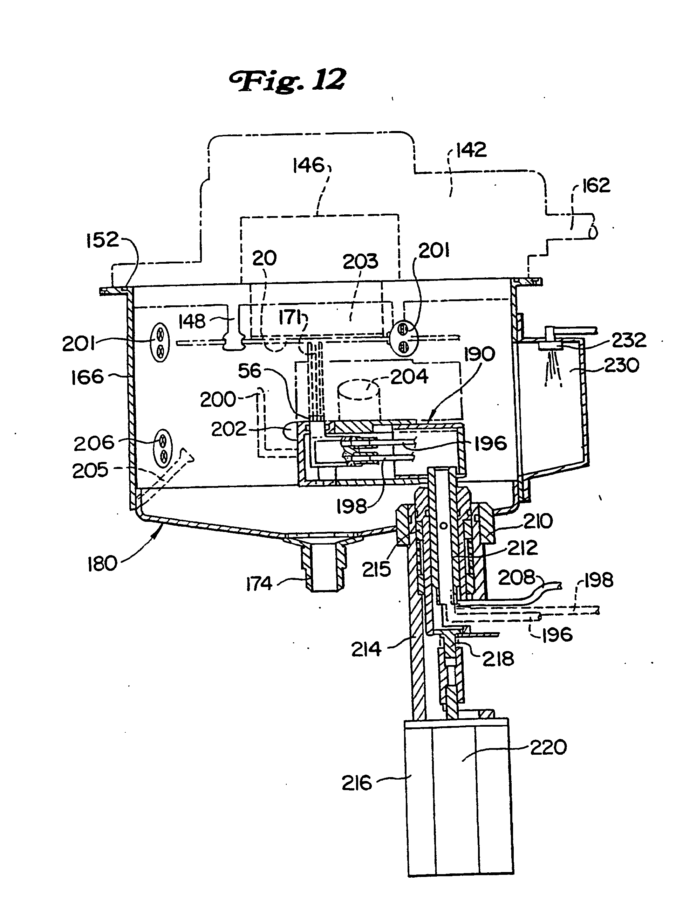

In an alternative process chamber 180, as shown in Fig 12, a jet nozzle 56 is provided on a swing arm assembly 190. The swing arm assembly 190 is supported on an axle 212 extending down through a pivot collar 210 passing through the bottom of a bowl 166. An arm elevator 214 is connected to the axle 212 through a bearing or bushing 215. The arm elevator 214 is connected to an arm elevator motor 216. The axle 212 is also directly or rigidly connected to an arm pivot linkage 218 driven by an arm pivot motor 220. Consequently, the swing arm assembly 190 can be raised or lowered by the arm elevator motor 216, and can also independently be pivoted by the arm pivot motor 220.

A rinse chamber 230 and a rinse spray nozzle 232 may be provided on one side of the bowl 166, for rinsing and cleaning off the swing arm assembly 190.

As shown in Figs. 8 and 12, a high-pressure liquid feed line 196 connects to the nozzle 56, preferably through the axle 212 and swing arm assembly 190. A steam feed line 198 may optionally similarly connect to a steam spray nozzle 200 attached to or on the swing arm assembly 190. Sonic transducers 202, such as ultrasonic or megasonic transducers, may be provided around the nozzle 56 on the swing arm assembly 190, to impart sonic energy into the jet of high pressure liquid emanating from the nozzle 56. An electromagnetic radiation source is also optionally provided on the swing arm assembly, to direct radiation at the workpiece 20. The electromagnetic radiation may be ultraviolet, infrared, microwave, gamma, or x-ray radiation. An electrical power line, fiber optic cable, or waveguide 208 connects to the electromagnetic radiation source 204, through the axle 212 and swing arm assembly 190.

Referring now to Fig. 8, the jet fluid 58 is stored in bulk in a tank or vessel 256 connected to a heater/chiller 264 by a supply line 258. A liquid chemical source or tank 260 is optionally connected to the liquid tank 256 by a chemical delivery line 262. Alternatively, the chemical supply tank 260 may be connected into the liquid supply line 258 at a point downstream of the heater/chiller 264. An ozone generator 72 is optionally connected into the liquid supply line 258, downstream of the heater/chiller 264, to supply ozone into the liquid. The ozone generator 72 may also be connected into the process chamber 180, at an ozone entry port 206 to supply ozone gas directly into the chamber.

The liquid supply line 258 from the heater/chiller 264 connects into a high-pressure pump 272, which pressurizes the liquid flowing into the feed line 296 extending up to the nozzle 56. A chemical gas supply 276 connecting into a chemical gas port 278 in the process chamber 180 may optionally be provided, in addition to the ozone generator 72. A steam generator or boiler 112 connected to the steam line 198 on the swing arm assembly 190, may also be provided.

Referring to Fig. 12, a sonic transducer 203 may be provided on the head 142, in contact with the workpiece 20 held by the holders or fixture 148. The direct contact transducer 203 may be a megasonic or ultrasonic transducer, and may be used in place of, or in addition to, the sonic transducers 202 at the nozzle 56.

Similarly, steam nozzles 201 supported on the inside surface of the bowl 166 and connected to the steam generator 112 may be used instead of, or in addition to, the steam nozzle 200 on the swing arm assembly 190. In addition, electromagnetic radiation sources 205, such as a UV lamp, may be provided within the process chamber 180 to irradiate the surface of the workpiece 20.

The foregoing description of the design and features shown in Fig. 12 applies as well to the embodiment shown in Fig. 11, having a linearly moving nozzle (instead of a nozzle moving along a radius R as shown in Fig. 13). The foregoing description similarly applies as well to an embodiment having a fixed nozzle and a workpiece which rotates and translates or precesses or otherwise moves to expose substantially all (downward facing) surfaces of the workpieces to the jet 62.

The liquid and gas chemical additives, irradiation sources and sonic transducers are not essential to the system or methods, but may be preferred in some applications. The heater/chiller ozone, and steam while preferred for many applications, may also be omitted. The essential features comprise the jet of high pressure liquid, and movement of the jet over the workpiece surface.

The valves, meters, filters and other standard components and techniques well known in the design of fluid systems have been omitted from Fig. 8, for clarity of illustration.

Referring to Fig. 10, in use, a workpiece container or carrier 130 is moved into the load/unload section 128 of the cleaning system 121. The robot 132 removes a single workpiece from the carrier 130. The head 142 of the process chamber 140 to be loaded is upfacing. The robot 132 places the workpiece 20 into the holders or fixture 148 on the upfacing head 142. The pivot drive motor 164 is then energized to pivot the head 142 (typically 180°) into a downfacing position. The head elevator 160 then lowers the head 142 and workpiece 20 down until the head 142 engages with the bowl 166.

Referring to Fig. 11, with the head 142 engaged onto the bowl 166, and optionally sealed via the seal 152, the head spin motor 146 is energized to rotate the workpiece 20. High pressure fluid is provided to the one or more nozzles 56 by the supply line 258 and the pump 272. The track motor 172 is energized to move the one or more nozzles 56 linearly within the process chamber 166. The spinning movement of the workpiece 20 and linear movement of the one or more nozzles 56 ensures that substantially all of the surfaces of the workpiece 20 facing the nozzle 56 are contacted by a jet 62 of the high-pressure liquid.

The operation of the embodiment shown in Fig. 12 is similar to the operation as described above regarding Fig. 11, except that the nozzle 56 moves on a radius R, as shown in Fig. 13, about the axle 212. The electromagnetic radiation source 204, sonic transducer 194 and steam nozzle 200 (if used) which move with the liquid jet nozzle 56 on the swing arm assembly 190 in Fig. 12, may also be provided on the manifold 154, or other structure around the nozzle 56, in the design shown in Fig. 11, to provided electromagnetic radiation, sonic, and steam sources which move with the jet nozzle 56.

Although the jet nozzles 56 are preferably oriented so that the jet 62 is perpendicular to the workpiece 20, jets striking the workpiece at an angle may also be used. Although the jet nozzles in Figs. 11 and 12 are positioned below the workpiece, the jet nozzles and workpiece may be oriented with the nozzle vertically above the workpiece, or at one side of the workpiece.

Referring to Figs. 8, 11, and 12, the liquid within the tank 256 is preferably water, or de-ionized water. However, other liquids may be used, alone, or mixed with water. For example, organic solvents such as isopropyl alcohol, n-methyl pyrolidone, sulfuric acid, phosphoric acid, or halogenated hydrocarbons may be used in place of, or mixed with, water. Water is preferred for the liquid in most applications. The advantages of using water include its low cost, small environmental impact, thermal capacity, and ability to dissolve many contaminants.

The liquid chemical additives within the chemical tanks 260 may include hydrofluoric acid, hydrochloric acid, ammonium hydroxide, or hydrogen peroxide. Hydroflouric acid, and hydrochloric acid can enhance metal removal capability. Hydroflouric acid can also perform as oxide etchant. Ammonium hydroxide increases the pH of the solution, which optimizes the wafer surface zeta potential, thereby decreasing the potential for particle adhesion to the wafer surface. Hydrogen peroxide can be added to enhance the removal of organic materials, such as hexamethyldisilazane, a photo resist adhesion promoter. While these and similar liquid chemicals may be added or used alone, the system and methods described may also just use a single liquid component, such as water, without any additives.

Referring still to Fig. 8, it is advantageous to heat the liquid 58, to speed up processing. When the liquid 58 is water, the heater/chiller 264 may be set to heat the liquid 58 to a temperature of from, e.g., 25°-99°C, and preferably from 40°-97°C, when using water as the liquid or principal liquid component. For many applications, the liquid 58 is preferably heated to just below its boiling point.

The liquid jet 62 mechanically or physically removes contaminants from the workpiece via kinetic energy. The kinetic energy of the jet, column, or bead 62 can be increased by increasing the density of the liquid 58. As the density of the liquid 58 increases, the mass of the liquid per second striking the workpiece surface increases. The kinetic energy imparted and available for removing contaminants will increase by the following equation:

Kinetic Energy = 0.5x (mass of liquid) x (velocity of liquid)2

Consequently, the kinetic energy available increases linearly with the density of the liquid. The density of the liquid can be increased by cooling the liquid to subambient temperatures, via the heater/chiller 264.

Ozone supplied by the ozone generator 72 may be delivered into the liquid supply line 258 or directly into the process chamber 166 at the ozone port 206. If the liquid 58 is heated by the heater/chiller 264, the solubility of ozone gas in the liquid will decrease. Consequently, some ozone delivered into the liquid supply line 258 may dissolve into the liquid, while excess ozone may form bubbles traveling with the liquid. Both the dissolved ozone and the bubbles of ozone in the liquid, if any, are helpful in the cleaning process.

The chemical gas supply 276 may be included to provide a reducing agent, such as hydrogen gas, into the chamber 180. The hydrogen gas or other reducing agent promotes the removal of contaminant materials, by reacting with them, and increasing their solubility in water.

Referring to Figs. 8 and 12, the steam generator 112 (if used) provides steam to the steam nozzles 200 and/or 201. Preferably the nozzles spray steam directly onto or across the workpiece. The simultaneous introduction of steam to the workpiece surface during the high pressure liquid cleaning process adds additional striping and cleaning capability. The steam temperature can vary from 100°-500°C. Although the increased molecular velocity of the steam striking the workpiece surface can function to physically remove contaminants, in a manner similar to the high pressure liquid jet, there is also another mechanism of removal that steam provides. As steam condenses on the workpiece surface, it releases about 2300 joules of energy per gram, due to the heat of condensation. This additional energy is then available to promote the removal contaminant materials on the workpiece surface. Table 1 below shows the time required to remove a 2.0 micron thick photoresist from a silicon wafer using various water/ozone methods in a single wafer platform.

**TABLE 1**

| **Process** | **Process Time** |
|---|---|
| Water (95°C) spray + Ozone | 5:00 |
| Steam (210°C) + Ozone | 3:00 |
| Water (95°C) at high pressure + Ozone | 1:30 |
| Steam (210°C) + Water (95°C) at high pressure + Ozone | 0:20 |

As shown in Table 1, the steam/high pressure liquid (water) process with ozone works synergistically to remove photoresist.

Referring still to Fig. 8, the liquid jet 62 mechanically removes organic materials, metallic contaminants and other contaminants from the workpiece. The sonic transducers 202 and/or 203 (if used) increase the energy imparted to the workpiece. Providing sonic energy to the workpiece can cause greater impact energy when the liquid jet 62 strikes the workpiece. As the liquid jet 62 forms a substantially incompressible column of liquid, sonic energy from the transducers 202 at the nozzle 56 are imparted to the workpiece through the jet 62.

The electromagnetic radiation sources 204 and/or 205 (if used) are preferably aimed and focused on the surface of the workpiece being cleaned. The entire surface of the workpiece may be simultaneously irradiated. Alternatively, the source 204 may be aimed and focused at the point of impact of the jet 62 on the workpiece 20, via lenses or a fiberoptic delivery device.

In the embodiment shown in Fig.12, the swing arm assembly 190 pivots on the axle 212 through angle θ, e.g., 40°-70°, so that, with rotational movement of the workpiece 20, the jet 62 from the nozzle contacts substantially all surfaces on the (downwardly facing) workpiece surface. The motor 146 spins the workpiece 20 at from 1-5,000 rpm, depending on the contaminant that is being removed. For photoresist removal, preferred spin rates range from 100-2,000 rpm.

The use of the high pressure liquid jet 62 can eliminate or greatly reduce the quantities of chemicals currently used for cleaning. The use of the high pressure liquid jet for cleaning, as described, can also replace some dry plasma etching processes, eliminating the need for dry etch plasma generators. Consequently, manufacturers of semiconductor and similar microelectronic devices and workpieces, can reduce manufacturing costs and lessen the environmental impact of their manufacturing processes, without reduction in cleaning performance.

The combination of various energy sources to remove surface contamination, including photoresist, particles, organic substances, and metals, increases the effectiveness of the removal process. Surface cleaning or preparation processes can be performed which are more efficient from a chemical consumption point of view, with reduced environmental impact, reduced cost, and improved manufacturing for semiconductor and related devices.

Photoresist is one example of a contaminant to be removed. Photoresist is a hydrocarbon compound, or a polymer with a hydrocarbon composition. Photoresist may be removed by chemically combining the polymer compound with a solvent. That solvent can be a wet chemical such as sulfuric acid, or a mixture of water and an oxidizer, such as ozone. Alternatively, the photoresist can be removed through combination with oxidizer such as oxygen suitably energized, such as electrically excited organic plasma. In any case, removing the contaminant, e.g., photoresist, requires the bond and/or mechanical energy which holds the hydrocarbon together to be overcome so that separate constituents can be combined with oxidizing agents or other solvents.

The use of water serves to hydrolyze carbon-carbon bonds of organic molecules, or combine with the H-C polymer, and serves to remove some degree of bonding energy with and between the hydrocarbons. Water also accelerates the oxidation of silicon surfaces by hydrolyzing silicon-hydrogen or silicon-hydroxyl bonds. The use of an oxidizer in addition to water increases the effectiveness of the oxidizing agent. In cases where the resist treatment includes exposure too highly charged media used for implanting into silicon, such as boron or arsenic, the resist becomes cross-linked, or more tightly bound. In this case, the use of less aggressive media such as ozone and water may not be enough to remove the photoresist. However, some degree of attack or oxidation does take place, although to a lesser extent due to the cross-linking phenomenon. Consequently, combining additional forms of energy (acoustic, electromagnetic, thermal and/or mechanical energy) to increase the removal effectiveness is advantageous. The use of megasonics or ultrasonics are examples of acoustic energy, whereas UV is an example of electromagnetic energy. High-pressure spray is an example of mechanical energy. Thermal energy can come in the form of steam, infrared heating, or other means of raising the temperature of the workpiece.

The combination of two or more of these energy sources provides novel techniques for removing contamination. For example, combining thermal energy in the form of infrared energy with ozone and water raises the temperature at the workpiece or wafer surface while simultaneously providing oxidizing agents. The use of high-pressure water in combination with ozone and a chemical such as ammonia, provides a combination of complimentary energy sources to make contamination or photoresist.

## Claims

1. A method for cleaning a workpiece (20) using ozone and a layer of a heated liquid on the workpiece (20),
**characterized by**:
directing a jet (62) of liquid through the layer of heated liquid, with the jet (62) penetrating through the layer and impacting against the surface of the workpiece (20), to physically remove a contaminant from the surface of the workpiece (20).

2. The method of claim 1, where the liquid includes water.

3. The method of claim 1, where the liquid is pressurized to about 3,500-14,000 kPa.

4. The method of claim 1 or 2, further **characterized by** heating the workpiece (20).

5. The method of claim 1 or 2, further **characterized by** heating the liquid to 25-99°C.

6. The method of claim 1, further **characterized by** providing the ozone as a dry gas into the environment around the workpiece (20).

7. The method of claim 6, further **characterized by** providing the ozone into the environment around the workpiece (20) by introducing ozone into the liquid used to form the jet (62).

8. The method of claim 1 or 2, further **characterized by** spinning the workpiece (20) to help form the boundary layer.

9. The method of claim 1 or 2, where the liquid includes hydrofluoric acid, hydrochloric acid, ammonium hydroxide, sulfuric acid, phosphoric acid, halogenated hydrocarbons, or hydrogen peroxide.

10. The method of claim 1 or 2, further **characterized by** irradiating the workpiece (20) with ultraviolet, infrared, microwave, gamma or x-ray radiation.

11. The method of claim 1 or 2, further **characterized by** moving the jet (62) of pressurized liquid relative to the workpiece (20), so that substantially all areas of the workpiece surface facing the jet (62) are exposed at least momentarily to the jet (62).

12. The method of claim 1 or 2, where the jet (62) is perpendicular to the workpiece (20) or at an oblique angle to the workpiece (20).

13. The method of claim 1 or 2, further including the step of moving the jet (62) on a swing arm (190) within the chamber.

14. The method of claim 1 or 2, further **characterized by** introducing sonic energy to the workpiece (20).

15. The method of claim 14, where the sonic energy is introduced to the workpiece (20) by introducing sonic energy into a nozzle (56) forming the liquid into the jet (62).

16. The method of claim 1, where the jet (62) has a diameter of from about 0.5-10 mm.

17. The method of claim 1, where the jet (62) is directed from below against the bottom surface of the workpiece (20) .

18. The method of claim 4, where the heating is performed by introducing steam to the workpiece (20).

19. An apparatus for removing contaminants from a workpiece (20), with the apparatus having a process chamber (15, 180, 166) ;
an ozone source (72) for introducing ozone into the chamber;
a fixture (30, 144) in the chamber (15, 180, 166) for holding one or more workpieces (20);
at least one jet nozzle (56) in the chamber (15, 180, 166) directed towards the workpiece (20); and
a nozzle or workpiece driver (220) for moving the nozzle (56) relative to the workpiece (20);
**characterized by**:
a high pressure source (272, 264, 256) of heated liquid connected to the nozzle (56), with the nozzle (56) configured to direct a jet (62) of liquid through a layer of heated fluid on the workpiece (20), with the jet (62) impacting against the surface of the workpiece (20) to physically remove a contaminant from the surface of the workpiece (20).

20. The apparatus of claim 19, where the high pressure liquid source (272, 264, 256) provides liquid to the nozzle (56) at a pressure of from 3,500-14,000 kPa.

21. The apparatus of claim 19, where the fixture (30, 144) rotates within the chamber (15, 180, 166).

22. The apparatus of claim 19, where the nozzle driver is **characterized by** a swing arm (190) supporting the nozzle (56) and an actuator (220) attached to the swing arm (190) .

23. The apparatus of claim 19, further **characterized by**: the process chamber (15, 180, 166) having an open position for loading and unloading a workpiece (20) and a closed position for processing the workpiece (20), a rotor (144) in the chamber (15, 180, 166) for holding and rotating the workpiece (20), at least one jet nozzle (56) in the chamber (15, 180, 166) directed towards the workpiece (20), and a nozzle driver (220) attached at least indirectly to the nozzle (56) for moving the nozzle (56) relative to the workpiece (20), and a robot (132) for loading and unloading the workpiece (20) into and out of the process chamber (15, 180, 166).

24. The apparatus of claim 19, further including a nozzle (40) in the process chamber (15) for directing a separate spray of ozone onto the surface of the workpiece (20).

25. A method for cleaning a workpiece (20) using ozone and a layer of a heated liquid on the workpiece (20),
**characterized by**:
directing a jet (62) of steam through the layer of liquid, with the jet (62) penetrating through the layer and impacting against the surface of the workpiece (20), to physically remove a contaminant from the surface of the workpiece (20).

26. The method of claim 25, further **characterized by** forming the layer of heated liquid via condensation of the steam.

## Patentansprüche

1. Ein Verfahren zur Reinigung eines Werkstücks (20) unter Verwendung von Ozon und einer Schicht einer erwärmten Flüssigkeit auf dem Werkstück (20), **gekennzeichnet durch**:
Richten eines Strahls (62) einer Flüssigkeit **durch** die Schicht der erwärmten Flüssigkeit, wobei der Strahl (62) durch die Schicht dringt und auf die Oberfläche des Werkstücks (20) einwirkt, um eine Verunreinigung von der Oberfläche des Werkstücks (20) physikalisch zu entfernen.

2. Das Verfahren nach Anspruch 1, wobei die Flüssigkeit Wasser beinhaltet.

3. Das Verfahren nach Anspruch 1, wobei die Flüssigkeit auf ungefähr 3.500 - 14.000 kPa unter Druck gesetzt wird.

4. Das Verfahren nach Anspruch 1 oder 2, das weiter durch Erwärmen des Werkstücks (20) charakterisiert wird.

5. Das Verfahren nach Anspruch 1 oder 2, das weiter durch Erwärmen der Flüssigkeit auf 25 - 99°C charakterisiert wird.

6. Das Verfahren nach Anspruch 1, das weiter durch Bereitstellen des Ozons als ein Trockengas in die Umgebung um das Werkstück (20) charakterisiert wird.

7. Das Verfahren nach Anspruch 6, das weiter durch Bereitstellen des Ozons in die Umgebung um das Werkstück (20) charakterisiert wird, indem das Ozon in die Flüssigkeit, die verwendet wird, um den Strahl (62) zu bilden, eingebracht wird.

8. Das Verfahren nach Anspruch 1 oder 2, das weiter durch Drehen des Werkstücks (20) charakterisiert wird, um die Bildung der Grenzschicht zu unterstützen.

9. Das Verfahren nach Anspruch 1 oder 2, wobei die Flüssigkeit Fluorwasserstoffsäure, Salzsäure, Ammoniumhydroxid, Schwefelsäure, Phosphorsäure, halogenierte Kohlenwasserstoffe oder Wasserstoffperoxid beinhaltet.

10. Das Verfahren nach Anspruch 1 oder 2, das weiter durch Bestrahlen des Werkstücks (20) mit Ultraviolet-, Infrarot-, Mikrowellen-, Gamma- oder Röntgenstrahlung charakterisiert wird.

11. Das Verfahren nach Anspruch 1 oder 2, das weiter durch Bewegen des Strahls (62) von unter Druck gesetzter Flüssigkeit relativ zu dem Werkstück (20) charakterisiert wird, so dass im wesentlichen alle Bereiche der Werkstückoberfläche, die dem Strahl (62) gegenüberliegen, mindestens für einen Moment dem Strahl (62) ausgesetzt werden.

12. Das Verfahren nach Anspruch 1 oder 2, wobei der Strahl (62) senkrecht zu dem Werkstück (20) oder in einem schiefen Winkel zu dem Werkstück (20) ist.

13. Das Verfahren nach Anspruch 1 oder 2, das weiter den Schritt des Bewegens des Strahls (62) auf einem Schwenkarm (190) innerhalb der Kammer beinhaltet.

14. Das Verfahren nach Anspruch 1 oder 2, das weiter durch Leiten von Schallenergie zu dem Werkstück (20) charakterisiert wird.

15. Das Verfahren nach Anspruch 14, wobei die Schallenergie zu dem Werkstück (20) geleitet wird indem Schallenergie in eine Düse (56), die die Flüssigkeit zu dem Strahl (62) formt, geleitet wird.

16. Das Verfahren nach Anspruch 1, wobei der Strahl (62) einen Durchmesser von ungefähr 0.5 - 10 mm hat.

17. Das Verfahren nach Anspruch 1, wobei der Strahl (62) von unten gegen die untere Fläche des Werkstücks (20) gerichtet wird.

18. Das Verfahren nach Anspruch 4, wobei das Erwärmen durch Einleiten von Dampf zu dem Werkstück (20) durchgeführt wird.

19. Ein Apparat zur Entfernung von Verunreinigungen von einem Werkstück (20), wobei der Apparat eine Prozeßkammer (15, 180, 166);
eine Ozonquelle (72) zum Einleiten von Ozon in die Kammer;
eine Halterung (30, 144) in der Kammer (15, 180, 166) zum Halten von einem oder mehreren Werkstücken (20);
mindestens eine Strahldüse (56) in der Kammer (15, 180, 166), die in Richtung des Werkstücks (20) gerichtet ist; und
einen Düsen- oder Werkstückantrieb (220) zum Bewegen der Düse (56) relativ zum Werkstück (20) hat; charakterisiert durch:
eine Hochdruckquelle (272, 264, 256) einer erwärmten Flüssigkeit, die mit einer Düse (56) verbunden ist, wobei die Düse (56) so konfiguriert ist, um einen Strahl (62) der Flüssigkeit durch eine Schicht erwärmter Flüssigkeit auf dem Werkstück (20) zu richten, wobei der Strahl (62) auf die Oberfläche des Werkstücks (20) einwirkt, um eine Verunreinigung von der Oberfläche des Werkstücks (20) physikalisch zu entfernen.

20. Der Apparat nach Anspruch 19, wobei die Quelle (272, 264, 256) der Hochdruckflüssigkeit Flüssigkeit in die Düse (56) bei einem Druck von 3.500 - 14.000 kPa bereitstellt.

21. Der Apparat nach Anspruch 19, wobei die Halterung (30, 144) innerhalb der Kammer (15, 180, 166) rotiert.

22. Der Apparat nach Anspruch 19, wobei der Düsenantrieb durch einen Schwenkarm (190) charakterisiert ist, der die Düse (56) und einen Antrieb (220), der an den Schwenkarm (190) angebracht ist, unterstützt.

23. Der Apparat nach Anspruch 19, der weiter charakterisiert ist durch: die Prozeßkammer (15, 180, 166) mit einer offenen Position zum Beladen und Entladen eines Werkstücks (20) und einer geschlossenen Position zum Bearbeiten des Werkstücks (20), einen Rotor (144) in der Kammer (15, 180, 166) zum Halten und Rotieren des Werkstücks (20), mindestens eine Strahldüse (56) in der Kammer (15, 180, 166), die in Richtung des Werkstücks (20) gerichtet ist, und einen Düsenantrieb (220), der mindestens indirekt an die Düse (56) angebracht ist, zum Bewegen der Düse (56) relativ zum Werkstück (20), und einen Automaten (132) zum Beladen und Entladen des Werkstücks (20) in und aus der Prozeßkammer (15, 180, 166).

24. Der Apparat nach Anspruch 19, der weiter eine Düse (40) in der Prozeßkammer (15) zum Richten eines separaten Sprühnebels von Ozon auf die Oberfläche des Werkstücks (20) beinhaltet.

25. Ein Verfahren zum Reinigen eines Werkstücks (20) unter Verwendung von Ozon und einer Schicht einer erwärmten Flüssigkeit auf dem Werkstück (20), charakterisiert durch:
Richten eines Strahls (62) von Dampf durch die Schicht der Flüssigkeit, wobei der Strahl (62) durch die Schicht dringt und auf die Oberfläche des Werkstücks (20) einwirkt, um eine Verunreinigung von der Oberfläche des Werkstücks (20) physikalisch zu entfernen.

26. Das Verfahren nach Anspruch 25, das weiter durch Bilden der Schicht von erwärmter Flüssigkeit mittels Kondensation des Dampfs charakterisiert wird.

## Revendications

1. Procédé de nettoyage d'une pièce à travailler (20) en utilisant de l'ozone et une couche d'un liquide chauffé sur la pièce à travailler (20), **caractérisée par** :
la direction d'un jet (62) de liquide à travers la couche de liquide chauffé, le jet (62) pénétrant la couche et frappant contre la surface de la pièce à travailler (20), de manière à éliminer physiquement un contaminant de la surface de la pièce à travailler (20).

2. Procédé selon la revendication 1, dans lequel le liquide comporte de l'eau.

3. Procédé selon la revendication 1, dans lequel le liquide est pressurisé entre 3500 et 14000 kPa environ.

4. Procédé selon la revendication 1 ou 2, **caractérisé, en outre, par** le chauffage de la pièce à travailler (20).

5. Procédé selon la revendication 1 ou 2, **caractérisé, en outre, par** le chauffage du liquide entre 25 et 99°C.

6. Procédé selon la revendication 1, **caractérisé, en outre, par** la fourniture de l'ozone sous la forme d'un gaz sec dans l'environnement autour de la pièce à travailler (20).

7. Procédé selon la revendication 6, **caractérisé, en outre, par** la fourniture de l'ozone dans l'environnement autour de la pièce à travailler (20) en introduisant de l'ozone dans le liquide utilisé afin de former le jet (62).

8. Procédé selon la revendication 1 ou 2, **caractérisé, en outre, par** la mise en rotation de la pièce à travailler (20) afin de faciliter la formation de la couche limite.

9. Procédé selon la revendication 1 ou 2, dans lequel le liquide comporte de l'acide fluorhydrique, de l'acide chlorhydrique, de l'hydroxyde d'ammonium, de l'acide sulfurique, de l'acide phosphorique, des hydrocarbures halogénés, ou du peroxyde d'hydrogène.

10. Procédé selon la revendication 1 ou 2, **caractérisé, en outre, par** l'irradiation de la pièce à travailler (20) avec un rayonnement ultraviolet, infrarouge, de micro-onde, de rayon gamma ou X.

11. Procédé selon la revendication 1 ou 2, **caractérisé, en outre, par** le déplacement du jet (62) de liquide pressurisé par rapport à la pièce à travailler (20), de telle sorte que sensiblement toutes les zones de la surface de pièce orientées face au jet (62) soient exposées au moins momentanément au jet (62).

12. Procédé selon la revendication 1 ou 2, dans lequel le jet (62) est perpendiculaire à la pièce à travailler (20) ou forme un angle oblique par rapport à la pièce à travailler (20).

13. Procédé selon la revendication 1 ou 2, comportant, en outre, l'étape de déplacement du jet (62) sur un bras oscillant (190) à l'intérieur de la chambre.

14. Procédé selon la revendication 1 ou 2, **caractérisé, en outre, par** l'introduction d'énergie sonore sur la pièce à travailler (20).

15. Procédé selon la revendication 14, dans lequel l'énergie sonore est introduite sur la pièce à travailler (20) en introduisant de l'énergie sonore dans un injecteur (56) destiné à mettre le liquide sous la forme du jet (62).

16. Procédé selon la revendication 1, dans lequel le jet (62) présente un diamètre de 0,5 à 10 millimètres environ.

17. Procédé selon la revendication 1, dans lequel le jet (62) est dirigé par le dessous contre la surface inférieure de la pièce à travailler (20).

18. Procédé selon la revendication 4, dans lequel le chauffage est réalisé par introduction de vapeur sur la pièce à travailler (20).

19. Dispositif destiné à éliminer des contaminants d'une pièce à travailler (20), le dispositif comportant une chambre de traitement (15, 180, 166) ;
une source d'ozone (72) destinée à introduire de l'ozone dans la chambre ;
un dispositif de retenue (30, 144) dans la chambre (15, 180, 166) destiné à supporter une ou plusieurs pièces à travailler (20) ;
au moins un injecteur de jet (56) dans la chambre (15, 180, 166) dirigé vers la pièce à travailler (20) ; et un dispositif d'entraînement d'injecteur ou de pièce à travailler (220) afin de déplacer l'injecteur (56) par rapport à la pièce à travailler (20) ;
**caractérisé par** :
une source à haute pression (272, 264, 256) de liquide chauffé reliée à l'injecteur (56), l'injecteur (56) étant configuré de manière à diriger un jet (62) de liquide à travers une couche de fluide chauffé sur la pièce à travailler (20), le jet (62) frappant contre la surface de la pièce à travailler (20) de manière à retirer physiquement un contaminant de la surface de la pièce à travailler (20).

20. Dispositif selon la revendication 19, dans lequel la source de liquide à haute pression (272, 264, 256) délivre du liquide à l'injecteur (56) sous une pression comprise entre 3500 à 14000 kPa.

21. Dispositif selon la revendication 19, dans lequel le dispositif de retenue (30, 144) tourne à l'intérieur de la chambre (15, 180, 166).

22. Dispositif selon la revendication 19, dans lequel le dispositif d'entraînement d'injecteur est **caractérisé par** un bras oscillant (190) supportant l'injecteur (56) et un actionneur (220) fixé sur le bras oscillant (190).

23. Dispositif selon la revendication 19, **caractérisé, en outre, par** : la chambre de traitement (15, 180, 166) présentant une position ouverte afin de charger et de décharger une pièce à travailler (20) et une position fermée afin de traiter la pièce à travailler (20), un rotor (144) dans la chambre (15, 180, 166) destiné à supporter et à faire tourner la pièce à travailler (20), au moins un injecteur (56) dans la chambre (15, 180, 166) dirigé vers la pièce à travailler (20), et un dispositif d'entraînement d'injecteur (220) fixé au moins indirectement à l'injecteur (56) afin de déplacer l'injecteur (56) par rapport à la pièce à travailler (20), et un robot (132) destiné à charger la pièce à travailler (20) dans la chambre de traitement (15, 180, 166) et à la décharger hors de celle-ci.

24. Dispositif selon la revendication 19, comportant, en outre, un injecteur (40) dans la chambre de traitement (15) afin de diriger un brouillard d'ozone distinct sur la surface de la pièce à travailler (20).

25. Procédé de nettoyage d'une pièce à travailler (20) en utilisant de l'ozone et une couche d'un liquide chauffé sur la pièce à travailler (20), **caractérisée par** :
la direction d'un jet (62) de vapeur à travers la couche de liquide, le jet (62) pénétrant la couche et frappant contre la surface de la pièce à travailler (20), de manière à retirer physiquement un contaminant de la surface de la pièce à travailler (20).

26. Procédé selon la revendication 25, **caractérisé, en outre, par** la formation de la couche de liquide chauffé par condensation de la vapeur.
